# FASCICULE DE BREVET EUROPEEN

(11) **EP 0 526 344 B1**
(45) Date de publication et mention de la délivrance du brevet: **08.03.1995**
(21) Numéro de dépôt: 92402203.1
(22) Date de dépôt: 31.07.1992
(51) Int. Cl.: C03C 17/245, C03C 17/00, C23C 16/40, C23C 16/44

(54) **Procédé de formation d'un dépôt comprenant de la silice sur une surface d'un objet en verre**
Verfahren zur Herstellung einer Siliziumdioxid enthaltenden Beschichtung auf der Oberfläche eines Glasgegenstands
Process for forming a coating containing silica on the surface of a glass object

(30) Priorité: 31.07.1991 FR 9109717
(43) Date de publication de la demande: 03.02.1993
(73) Titulaire: L'AIR LIQUIDE, SOCIETE ANONYME POUR L'ETUDE ET L'EXPLOITATION DES PROCEDES GEORGES CLAUDE, 75007 Paris (FR)
(72) Inventeur: Dick, Sami, F-78150 Le Chesnay (FR); Genies, Bernard, F-91440 Bures sur Yvette (FR); Ougarane, Lahcen, F-78180 Montigny le Bretonneux (FR); Recourt, Patrick, F-91460 Marcoussis (FR)
(74) Mandataire: Le Moenner, Gabriel

(56) Documents cités:
- EP-A- 0 213 045
- PATENT ABSTRACTS OF JAPAN vol. 2, no. 93 (C-19)29 Juillet 1978 and JP-A-53054181
- PATENT ABSTRACTS OF JAPAN vol. 13, no. 384 (C-629)(3732) 24 Août 1989 and JP-A-1 132 769

## Description

La présente invention concerne les procédés de formation d'un dépôt comprenant de la silice sur une surface d'un objet en verre par projection d'un mélange gazeux comprenant un gaz neutre majoritaire, un précurseur du silicium et de l'oxygène sur la surface chaude de l'objet au moyen d'au moins une buse de projection.

Un procédé de ce type est connu du document US-A-3.717.498 où la projection est effectuée de façon confinée dans un tube. Plus récemment, le document GB-A-2.234.264 décrit un procédé similaire, pour du verre plat, où l'injection s'effectue dans une chambre de revêtement recouvrant la zone à revêtir et elle-même enclose dans une hotte aspirante munie de jupes d'étanchéité.

La présente invention a pour objet de proposer un procédé du type ci-dessus, convenant notamment pour la formation sur la surface d'un objet en verre, notamment sodo-calcique ou fluorosilicate, de couches barrières anti-migration, en particulier de sodium sur les verres sodo-calciques, et pour l'augmentation de la résistance de l'objet en verre aux milieux alcalins, notamment aux produits détergents, permettant d'effectuer de façon simple et particulièrement souple des dépôts de qualité sur un grand nombre d'objets en verre, et autorisant de ce fait des coûts d'installation et de production notablement réduits.

Pour ce faire, selon une caractéristique de l'invention, la projection est effectuée sur la surface chaude de l'objet en verre en atmosphère ambiante non confinée, typiquement à l'air libre.

Selon une caractéristique plus particulière de l'invention, la teneur en précurseur du silicium, typiquement un silane, dans le mélange gazeux est comprise entre 0,5 et 2 %, typiquement d'environ 1 %, la teneur en oxygène dans le mélange gazeux étant comprise entre 3,5 et 30 %, typiquement entre 7 et 15 %.

Selon une autre caractéristique de l'invention, on adjoint au mélange gazeux à projeter de l'hydrogène, à une teneur typiquement inférieure à 5 %.

Selon des caractéristiques plus particulières de l'invention, la teneur en hydrogène dans le mélange gazeux est compris entre 0,1 et 5 %, typiquement supérieure à 2 % et avantageusement d'environ 3 %, la teneur en précurseur du silicium, typiquement un silane, avantageusement le monosilane, étant comprise entre 0,1 et 2 %, avantageusement d'environ 1 %, la teneur en oxygène dans le mélange gazeux étant comprise entre 3,5 et 30 %, le rapport volumique entre l'oxygène et le précurseur de silicium étant de préférence compris entre 5 et 20, typiquement supérieur à 7, le rapport volumique entre l'hydrogène et le silane étant de préférence supérieur à 2, typiquement d'environ 3.

Selon une autre caractéristique de l'invention, la surface de verre à traiter est chauffée sélectivement juste avant la projection du mélange gazeux, à l'air libre, sur la surface chauffée.

La Demanderesse a constaté que, de façon surprenante, dans les conditions sus-mentionnées, par la projection à l'air libre du mélange gazeux sur la surface de verre chaude (à une température comprise entre environ 300° et la température de formage du verre), on obtenait le dépôt d'une couche homogène, uniforme, non granulaire et stoechiométrique de silice ou de silice hydrogénée sans qu'il y ait de redéposition notable sur cette couche de particules isolées contenant de la silice.

La présente invention sera mieux comprise au vu de la description suivante de modes de réalisation, donnée à titre illustratif, faite en relation avec les dessins annexés, sur lesquels :
- la figure 1 est une vue schématique d'un premier mode de réalisation d'une installation pour la mise en oeuvre du procédé selon l'invention ; et
- les figures 2 et 3 sont des vues schématiques d'autres modes de réalisation de l'invention.

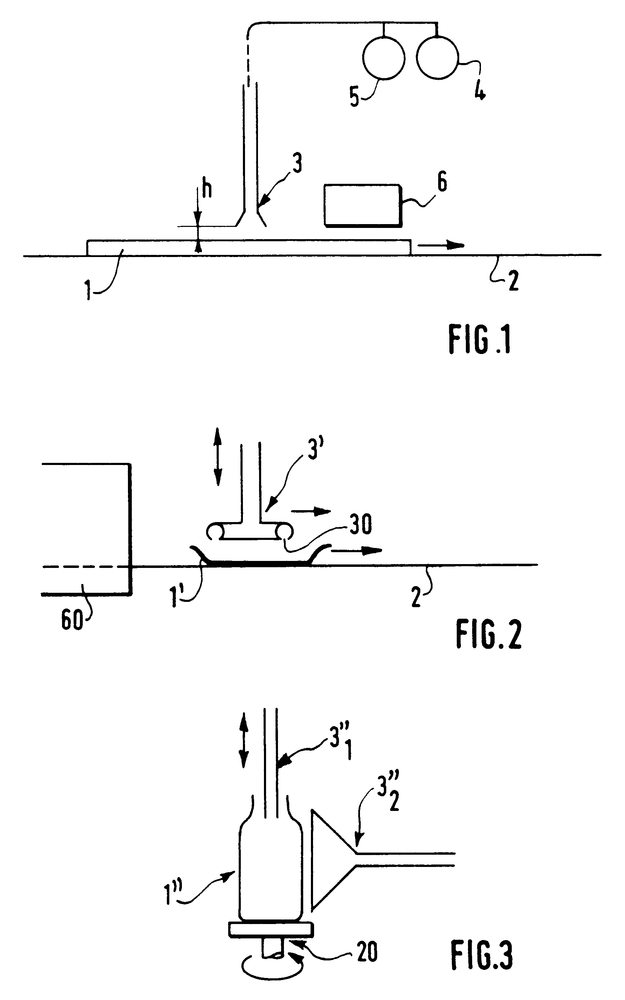

On a représenté schématiquement sur la figure 1 une plaque de verre 1 acheminée à l'air libre sur une bande transporteuse 2 sur le trajet de laquelle est disposée une buse 3 de projection d'un mélange ternaire silane-oxygène-azote pour la formation, sur la surface supérieure de la plaque 1, d'une couche de silice. Dans ce mode de réalisation, la buse 3 définit une fente de projection transversale à la direction d'avancement relatif de la plaque 1 et est alimentée en mélange ternaire à partir d'un réservoir 4 contenant un mélange binaire d'azote et de silane et d'un réservoir 5 d'oxygène gazeux. La buse de projection 3 peut être disposée directement en aval d'un four de flottage d'où la plaque de verre 1 sort à la température requise. Le poste de projection peut être toutefois prévu indépendamment de tout four, auquel cas, typiquement, un poste de chauffe 6, par exemple à infrarouges, sera disposé juste en amont du poste de projection dans le sens de défilement de la plaque 1.

Dans ce mode de réalisation, la distance h entre l'extrémité de la buse 3 et la surface à revêtir de la plaque 1 est inférieure à 15 mm, et comprise typiquement entre 3 et 10 mm, la vitesse d'éjection du mélange étant comprise entre 5 et 30 m/seconde, selon la largeur de la fente.

La teneur en silane dans le mélange gazeux est comprise entre 0,5 et 2 %, de préférence entre 0,8 et 1 %, la teneur en oxygène dans le mélange gazeux étant comprise entre 3,5 et 30 %, de préférence entre 7 et 15 %, le rapport volumique oxygène/silane étant compris entre 5 et 30, typiquement entre 7 et 15, de préférence entre 7 et 10.

Dans ces conditions, avec une vitesse de défilement relative entre la plaque et la buse de 5 cm/seconde et un nombre de passages successifs correspondant à un temps d'injection réel sur une zone élémentaire de la plaque portée à une température entre 550°C et 600°C, d'environ 9 secondes, on obtient une couche de silice stoechiométrique d'épaisseur uniforme d'environ 0,7 um présentant un nombre de particules non liées redéposées d'une dimension ne dépassant pas 0,2 um inférieur à 10/mm². Des résultats similaires sont obtenus avec, au lieu d'azote, de l'argon qui permet de réduire légèrement la durée de projection du mélange gazeux pour l'obtention d'une couche barrière efficace. Un test de résistance aux milieux alcalins (attaque alcaline, pendant 15 minutes, d'une solution bouillante de 0,5 mole/ litre de Na₂CO₃ et d'une mole/litre de NaOH, suivie d'une deuxième attaque de 15 minutes, avec une même solution bouillante) et mesure des intensités de fluorescence X révèle une résistance de la couche de silice à l'attaque basique non inférieure à 30 minutes.

Suivant un autre aspect de l'invention, on ajoute au mélange gazeux de gaz neutre, de silane et d'oxygène, entre 0,1 et 5 % d'hydrogène sans modifier sensiblement les conditions opératoires si ce n'est que le mélange gazeux contenant l'hydrogène est maintenu, jusqu'à son éjection, à une température inférieure à 200°C, typiquement inférieure à 150°C, et est projeté à l'air libre sur la surface à traiter pendant au moins 2 secondes, typiquement entre 5 et 20 secondes selon la géométrie et la finalité de l'objet en verre. La surface du verre à traiter est, ici également, préalablement chauffée à une température entre 300°C et la température de formage du verre ou du cristal, typiquement à une température entre 500 et 600°C.

Le mélange gazeux est constitué majoritairement d'un gaz neutre diluant, tel que l'azote ou l'argon. Le précurseur gazeux du silicium est avantageusement un silane, tel que le monosilane, le disilane ou le trisilane. La teneur en silane dans le mélange gazeux varie entre 0,1 % et la limite inférieure d'inflammabilité du silane selon les autres constituants du mélange gazeux, par exemple 3 % dans le cas de monosilane avec de l'azote comme gaz diluant. La teneur en oxygène est comprise entre 3,5 et 30 %. La teneur en hydrogène varie entre 0,1 % et la limite inférieure d'inflammabilité de l'hydrogène dans les conditions du procédé.

Le tableau ci-dessous montre les performances de la résistance hydrolytique de dépôts de couches à base de silice ou de silice hydrogénée obtenus selon l'invention dans différentes conditions opératoires. Le test appliqué est le suivant : un flacon en verre sodo-calcique, dans lequel a été injecté un mélange gazeux selon l'invention pour y former une couche à base de silice, est rempli d'eau distillée, puis est porté à 80°C pendant 48 heures. On dose ensuite le sodium extrait du verre, par exemple par spectrométrie de flamme.

### Migration du sodium en ug/ml :

| Temps de traitement | 5s | 15s |
|---|---|---|
| Témoin non traité | 8 | 8 |
| Traitement A | 4 | - |
| Traitement B | 2,58 | 0,5 |
| Traitement C | 2,32 | 0,1 |

### Conditions opératoires :

- température du verre : 570°C
- débit du mélange gazeux : 100 l/h
- traitement A : SiH4 : 1 %, 02 : 7 % N2 : 92 %
- traitement B : SiH4 : 1 %, 02 : 7 %, H2 : 3 %, N2 : 89 %
- traitement C : SiH4 : 1 %, 02 : 16 %, H2 : 3 %, N2 : 80 %

On notera que, par rapport au traitement A, qui correspond au procédé sans hydrogène décrit ci-dessus, qui divisait déjà par deux la⁻quantité de sodium migrant par rapport à un témoin non traité, le procédé mettant en oeuvre de l'hydrogène permet de diviser cette quantité par plus de trois, avec un temps de traitement de 5 secondes et par plus de 15, avec un temps de traitement de 15 secondes.

La grande simplicité du procédé selon l'invention, permettant d'effectuer des dépôts à l'air libre, autorise un grand nombre d'applications à des objets en verre de formes diverses, avec des épaisseurs de couche variables selon le temps et la vitesse d'injection du mélange gazeux, la teneur en silane, en oxygène et en hydrogène du mélange, et la température de la surface à traiter.

On a représenté sur la figure 2 l'application du procédé au revêtement de la surface interne d'une soucoupe ou d'une assiette 1' sortant d'un four de réchauffe 60. Dans ce mode de réalisation, la buse d'injection 3' est conformée à la façon d'un tore comportant une fente d'injection circulaire 30 de diamètre adapté à celui de la soucoupe 1', la buse 3' étant abaissée au-dessus de la soucoupe 1' à sa sortie du four 60, de formage ou de réchauffe, et accompagnant le déplacement de cette dernière pendant une durée comprise entre 3 et 20 secondes, selon l'épaisseur de couche de dépôt désirée. La buse peut également présenter une surface d'éjection poreuse de dimension et de forme correspondant étroitement à celles de l'objet à traiter. Les mêmes mélanges gazeux que précédemment sont utilisés.

Dans le mode de réalisation de la figure 3, l'objet en verre à revêtir est ici constitué d'un flacon 1'' qui, encore chaud, est placé sur un support tournant 20. Une première buse cylindrique 3''₁ est introduite dans le col du flacon 1'' tandis qu'une seconde buse 3''₂ présentant une fente d'éjection parallèle à une génératrice du flacon 1'' est disposée au voisinage de la paroi externe de ce dernier. Les mêmes mélanges gazeux que précédemment sont éjectés par les deux buses 3''₁ et 3''₂, le temps d'injection à l'intérieur du flacon étant compris entre 3 et 5 secondes, ce qui permet une intégration aisée dans une chaîne de production industrielle.

## Revendications

1. Procédé de formation d'un dépôt de silice sur une surface d'un objet en verre (1,1',1'') par projection d'un mélange gazeux comprenant un gaz neutre majoritaire, un précurseur du silicium et de l'oxygène sur la surface chaude de l'objet en verre au moyen d'au moins une buse de projection (3;3';3''₁,3''₂), caractérisé en ce que la projection est effectuée sur la surface chaude en atmosphère ambiante non confinée.

2. Procédé selon la revendication 1, caractérisé en ce qu'on chauffe sélectivement (6) au moins la surface à traiter de l'objet en verre juste avant la projection du mélange gazeux.

3. Procédé selon la revendication 1 ou la revendication 2, caractérisé en ce que la buse (3;3';3''₁,3''₂) est animée d'un mouvement relatif par rapport à la surface à traiter.

4. Procédé selon l'une des revendications 1 à 3, caractérisé en ce que la buse comporte au moins un orifice d'éjection adapté à la géométrie de la surface à traiter.

5. Procédé selon l'une des revendications 1 à 4, caractérisé en ce que la distance (h) entre la buse (3;3';3''₂) et la surface à traiter est inférieure à 15 mm.

6. Procédé selon la revendication 5, caractérisé en ce que la distance (h) est comprise entre 3 et 10 mm.

7. Procédé selon l'une des revendications précédentes, caractérisé en ce que la vitesse d'éjection du mélange est comprise entre 5 et 30 m/s.

8. Procédé selon l'une des revendications précédentes, caractérisé en ce que le précurseur du silicium est un silane dont la teneur dans le mélange gazeux est comprise entre 0,5 et 2 % environ.

9. Procédé selon la revendication 8, caractérisé en ce que la teneur en silane est d'environ 1 %.

10. Procédé selon l'une des revendications 8 ou 9, caractérisé en ce que la teneur en oxygène dans le mélange gazeux est comprise entre 3,5 et 30 % environ.

11. Procédé selon la revendication 10, caractérisé en ce que la teneur en oxygène est comprise entre 7 et 15 % environ.

12. Procédé selon l'une des revendications 9 à 11, caractérisé en ce que le rapport volumique entre l'oxygène et le silane dans le mélange gazeux est d'environ 7.

13. Procédé selon l'une des revendications 1 à 11, caractérisé en ce qu'il comporte l'étape d'adjoindre de l'hydrogène au mélange gazeux à projeter.

14. Procédé selon la revendication 13, caractérisé en ce que la teneur en hydrogène dans le mélange gazeux est comprise entre 0,1 et 5 %.

15. Procédé selon la revendication 14, caractérisé en ce que la teneur en précurseur du silicium dans le mélange gazeux est comprise entre 0,1 % et 2 % environ.

16. Procédé selon la revendication 15, caractérisé en ce que la teneur en oxygène dans le mélange gazeux est comprise entre 3,5 et 30 % environ.

17. Procédé selon la revendication 16, caractérisé en ce que le rapport volumique, dans le mélange gazeux, entre l'oxygène et le précurseur du silicium est compris entre 5 et 20.

18. Procédé selon la revendication 17, caractérisé en ce que le précurseur du silicium est un silane.

19. Procédé selon la revendication 18, caractérisé en ce que la teneur en silane dans le mélange gazeux est d'environ 1 %.

20. Procédé selon la revendication 19, caractérisé en ce que le rapport volumique, dans le mélange gazeux, entre l'hydrogène et le silane est supérieur à 2.

21. Procédé selon la revendication 19 ou la revendication 20, caractérisé en ce que le rapport volumique, dans le mélange gazeux, entre l'oxygène et le silane est supérieur à 7.

22. Procédé selon l'une des revendications 19 à 21, caractérisé en ce que la teneur en hydrogène dans le mélange gazeux est d'environ 3 %.

23. Procédé selon l'une des revendications 13 à 22, caractérisé en ce que la température du mélange gazeux est maintenue inférieure à 200°C jusqu'à son éjection.

24. Procédé selon l'une des revendications précédentes, caractérisé en ce que le mélange gazeux est projeté sur la surface de l'objet en verre pendant au moins 2 secondes.

25. Procédé selon la revendication 24, caractérisé en ce que le mélange gazeux est projeté sur la surface pendant une durée comprise entre environ 5 et 20 secondes.

26. Procédé selon l'une des revendications précédentes, caractérisé en ce que le gaz neutre est l'azote.

27. Procédé selon l'une des revendications 1 à 25, caractérisé en ce que le gaz neutre est l'argon.

## Claims

1. Process for the formation of a deposit comprising silica on a surface of a glass object (1, 1', 1'') by projecting a gaseous mixture comprising a neutral gas as the major constituent, a silicon precursor and oxygen onto the hot surface of the glass object by means of at least one projection nozzle (3;3';3''₁,3''₂), characterized in that the projection is carried out onto the hot surface in an unconfined ambient atmosphere.

2. Process according to Claim 1, characterized in that at least one surface of the glass object to be treated is selectively heated (6) just before projecting the gaseous mixture.

3. Process according to Claim 1 or Claim 2, characterized in that the nozzle (3;3';3''₁,3''₂) is caused to move relative to the surface to be treated.

4. Process according to one of Claims 1 to 3, characterized in that the nozzle comprises at least one ejection orifice adapted to the geometry of the surface to be treated.

5. Process according to one of Claims 1 to 4, characterized in that the distance (h) between the nozzle (3;3';3''₂) and the surface to be treated is less than 15 mm.

6. Process according to Claim 5, characterized in that the distance (h) lies between 3 and 10 mm.

7. Process according to one of the preceding claims, characterized in that the ejection velocity of the mixture lies between 5 and 30 m/s.

8. Process according to one of the preceding claims, characterized in that the silicon precursor is a silane, the concentration of which in the gaseous mixture lies between approximately 0.5 and 2 %.

9. Process according to Claim 8, characterized in that the silane concentration is approximately 1 %.

10. Process according to either of Claims 8 or 9, characterized in that the oxygen concentration in the gaseous mixture lies between approximately 3.5 and 30 %.

11. Process according to Claim 10, characterized in that the oxygen concentration lies between approximately 7 and 15 %.

12. Process according to one of Claims 9 to 11, characterized in that the volume ratio between oxygen and silane in the gaseous mixture is approximately 7.

13. Process according to one of Claims 1 to 11, characterized in that it comprises a stage in which hydrogen is added to the gaseous mixture to be projected.

14. Process according to Claim 13, characterized in that the hydrogen concentration in the gaseous mixture lies between 0.1 and 5 %.

15. Process according to Claim 14, characterized in that the concentration of silicon precursor in the gaseous mixture lies between approximately 0.1 % and 2 %.

16. Process according to Claim 15, characterized in that the oxygen concentration in the gaseous mixture lies between approximately 3.5 and 30 %.

17. Process according to Claim 16, characterized in that the volume ratio, in the gaseous mixture, between the oxygen and the silicon precursor lies between 5 and 20.

18. Process according to Claim 17, characterized in that the silicon precursor is a silane.

19. Process according to Claim 18, characterized in that the silane concentration in the gaseous mixture is approximately 1 %.

20. Process according to Claim 19, characterized in that the volume ratio in the gaseous mixture, between hydrogen and silane is greater than 2.

21. Process according to Claim 19 or Claim 20, characterized in that the volume ratio, in the gaseous mixture, between oxygen and silane is greater than 7.

22. Process according to one of Claims 19 to 21, characterized in that the hydrogen concentration in the gaseous mixture is approximately 3 %.

23. Process according to one of Claims 13 to 22, characterized in that the temperature of the gaseous mixture is maintained at less than 200°C until ejection.

24. Process according to one of the preceding Claims characterized in that the gaseous mixture is projected onto the surface of the glass object for at least 2 seconds.

25. Process according to Claim 24, characterized in that the gaseous mixture is projected onto the surface for a period of between 5 and 20 seconds.

26. Process according to one of the preceding Claims characterized in that the neutral gas is nitrogen.

27. Process according to one of Claims 1 to 25 characterized in that the neutral gas is argon.

## Patentansprüche

1. Verfahren zur Herstellung einer Siliciumdioxidbeschichtung auf einer Oberfläche eines Glasgegenstands (1,1',1'') durch Blasen eines Gasgemisches aus einem überwiegenden Anteil eines neutralen Gases aus einem Siliciumvorläufer und aus Sauerstoff auf die warme Oberfläche des Glasgegenstands mittels zumindest einer Blasdüse (3;3';3''₁,3''₂), dadurch gekennzeichnet, daß das Blasen auf die warme Oberfläche in nicht begrenzter Umgebungsatmosphäre ausgeführt wird.

2. Verfahren nach Anspruch 1, dadurch gekennzeichnet, daß zumindest die zu behandelnde Oberfläche des Glasgegenstands unmittelbar vor dem Aufblasen des Gasgemisches selektiv (6) erwärmt wird.

3. Verfahren nach Anspruch 1 oder 2, dadurch gekennzeichnet, daß die Düse (3;3';3''₁,3''₂) relativ zu der zu behandelnden Oberfläche bewegt wird.

4. Verfahren nach einem der Ansprüche 1 bis 3, dadurch gekennzeichnet, daß die Düse zumindest eine Blasöffnung umfaßt, die an die Geometrie der zu behandelnden Oberfläche angepaßt ist.

5. Verfahren nach einem der Ansprüche 1 bis 4, dadurch gekennzeichnet, daß der Abstand (h) zwischen der Düse (3;3';3''₂) und der zu behandelnden Oberfläche geringer als 15 mm ist.

6. Verfahren nach Anspruch 5, dadurch gekennzeichnet, daß der Abstand (h) zwischen 3 und 10 mm beträgt.

7. Verfahren nach einem der vorangehenden Ansprüche, dadurch gekennzeichnet, daß die Gemischaustrittsgeschwindigkeit zwischen 5 und 30 m/s beträgt.

8. Verfahren nach einem der vorangehenden Ansprüche, dadurch gekennzeichnet, daß der Siliciumvorläufer Silan ist, dessen Gehalt im Gasgemisch zwischen ungefähr 0,5 und 2% beträgt.

9. Verfahren nach Anspruch 8, dadurch gekennzeichnet, daß der Silangehalt ungefähr 1% beträgt.

10. Verfahren nach Anspruch 8 oder 9, dadurch gekennzeichnet, daß der Sauerstoffgehalt in dem Gasgemisch ungefähr zwischen 3,5 und 30% beträgt.

11. Verfahren nach Anspruch 10, dadurch gekennzeichnet, daß der Sauerstoffgehalt zwischen ungefähr 7 und 15% beträgt.

12. Verfahren nach einem der Ansprüche 9 bis 11, dadurch gekennzeichnet, daß das Volumenverhältnis zwischen Sauerstoff und Silan in dem Gasgemisch etwa 7 beträgt.

13. Verfahren nach einem der Ansprüche 1 bis 11, dadurch gekennzeichnet, daß es den Schritt umfaßt, dem zu blasenden Gasgemisch Wasserstoff zuzusetzen.

14. Verfahren nach Anspruch 13, dadurch gekennzeichnet, daß der Wasserstoffgehalt in dem Gasgemisch zwischen 0,1 und 5% beträgt.

15. Verfahren nach Anspruch 14, dadurch gekennzeichnet, daß der Siliciumvorläufergehalt in dem Gasgemisch zwischen ungefähr 0,1% und 2% beträgt.

16. Verfahren nach Anspruch 15, dadurch gekennzeichnet, daß der Sauerstoffgehalt in dem Gasgemisch zwischen ungefähr 3,5 und 30% beträgt.

17. Verfahren nach Anspruch 16, dadurch gekennzeichnet, daß das Volumenverhältnis zwischen Sauerstoff und dem Siliciumvorläufer in dem Gasgemisch zwischen 5 und 20 beträgt.

18. Verfahren nach Anspruch 17, dadurch gekennzeichnet, daß der Siliciumvorläufer ein Silan ist.

19. Verfahren nach Anspruch 18, dadurch gekennzeichnet, daß der Silangehalt in dem Gasgemisch ungefähr 1% beträgt.

20. Verfahren nach Anspruch 19, dadurch gekennzeichnet, daß das Volumenverhältnis zwischen Wasserstoff und Silan in dem Gasgemisch größer als 2 ist.

21. Verfahren nach Anspruch 19 oder 20, dadurch gekennzeichnet, daß das Volumenverhältnis zwischen Sauerstoff und Silan in dem Gasgemisch größer als 7 ist.

22. Verfahren nach einem der Ansprüche 19 bis 21, dadurch gekennzeichnet, daß der Wasserstoffgehalt in dem Gasgemisch ungefähr 3% beträgt.

23. Verfahren nach einem der Ansprüche 13 bis 22, dadurch gekennzeichnet, daß die Temperatur des Gasgemisches bis zu seinem Ausblasen auf weniger als 200°C gehalten wird.

24. Verfahren nach einem der vorangehenden Ansprüche, dadurch gekennzeichnet, daß das Gasgemisch für zumindest 2 Sekunden auf die Oberfläche des Glasgegenstands geblasen wird.

25. Verfahren nach Anspruch 24, dadurch gekennzeichnet, daß das Gasgemisch für eine Dauer zwischen ungefähr 5 und 20 Sekunden auf die Oberfläche geblasen wird.

26. Verfahren nach einem der vorangehenden Ansprüche, dadurch gekennzeichnet, daß das neutrale Gas Stickstoff ist.

27. Verfahren nach einem der Ansprüche 1 bis 25, dadurch gekennzeichnet, daß das neutrale Gas Argon ist.
